# EUROPEAN PATENT APPLICATION

(11) **EP 1 394 286 A1**
(43) Date of publication of application: **03.03.2004**
(21) Application number: 03447211.8
(22) Date of filing: 18.08.2003
(51) Int. Cl.: C23C 16/02, C23C 16/455, H01L 21/28, H01L 21/3205

(54) **Pretreatment of an organic layer for ALD thereof**

(30) Priority: 15.08.2002 US 404037 P
(71) Applicant: Interuniversitaire Microelectronica Centrum vzw ( IMEC), 3001 Leuven (BE)
(72) Inventor: Schuhmacher, Jorg, 1390 Grez-Doiceau (BE); Martin Hoyas, Ana, 3000 Leuven (BE); Schaekers, Marc, 3001 Leuven (BE); Vanhaelemeersch, Serge, 3001 Leuven (BE)
(74) Representative: Van Malderen, Joelle

(57) **Abstract**

The present invention relates to a method for depositing a layer on a surface of a dielectric layer, said dielectric layer comprising an organic containing material, said method comprising the steps of :
a) exposing said surface of said dielectric layer to a nitrogen containing gaseous substance, thereby modifying at least the exposed surface of said dielectric layer,
b) depositing a layer by an atomic layer deposition process on said exposed surface of said dielectric layer.

The present invention further relates to a substrate comprising a dielectric layer comprising an organic containing material, said dielectric layer having in a first region (11) and a second region (22), said first region having a first amount of nitrogen incorporated and said second region having a second amount of nitrogen incorporated in said dielectric layer, the amount of nitrogen in said second region (22) being higher than the amount of nitrogen in said first region; and a further layer (23), said layer being in contact with said second region of said dielectric layer and said layer being deposited by atomic layer deposition.

## Description

### Field of the invention

The present invention relates to a substrate useful for semiconductor processing, and a method of producing said substrate.

### Background of the invention

Substrates, useful for semiconductor processing, are generally produced by material deposition methods such as Physical Vapor Deposition (PVD) and Chemical Vapor Deposition (CVD).

In the Chemical Vapor Deposition method (CVD), the source materials are typically fed to reaction space together, and they react with each other when brought into contact with a first substrate to form a second substrate. It is also possible to feed one source material containing all desired reactant species to a CVD reactor, and heat it almost to a point where it decomposes thermally. When the heated gas contacts the substrate surface, a cracking reaction occurs and a film is grown. As is apparent from the above discussion, in CVD the concentration of the different source materials in the reaction space determines the growth of the film. Atomic Layer Deposition (ALD) and, originally, Atomic Layer Epitaxy (ALE) is an advanced variation of CVD. The method name was changed from ALE into ALD to avoid possible confusion when discussing about polycrystalline and amorphous thin films. The ALD method is based on sequential self-saturated surface reactions. The method is described in detail in US Patents Nos. 4,058,430 and 5,711,811. The reactor design benefits from the usage of inert carrier and purging gases, which makes the system fast.

The separation of source chemicals from each other by inert gases prevents gas-phase reactions between gaseous reactants and enables self-saturated surface reactions leading to film growth, which requires neither strict temperature control of the substrates nor precise dosage control of source chemicals. Surplus chemicals and reaction byproducts are always removed from the reaction chamber before the next reactive chemical pulse is introduced into the chamber. Undesired gaseous molecules are effectively expelled from the reaction chamber by keeping the gas flow speeds high with the help of an inert purging gas. The purging gas pushes the extra molecules towards the vacuum pump used for maintaining a suitable pressure in the reaction chamber. ALD provides self-control for the film growth.

ALD film growth can be divided into two regions; transient and converged (J. W. Lim, H. S. Park, and S. W. Kang, J. Electrochem. Soc., 148 (2001) C403). The growth mechanism during the transient period is dependent on the nature of the substrate surface and independent thereon in the converged or linear part. The starting surface condition controls the film evolution, and as a consequence ALD films obtained by applying a constant number of deposition cycles and constant deposition parameters on different substrates have different properties. That emphasizes the importance of surface preparation as means of controlling and improving the ALD growth.

The use of plasmas to modify surfaces in connection with ALD is known for high dielectric constant ALD layers on oxides. WO0243115 discloses a method of depositing a film over a surface in a partially fabricated integrated circuit, comprising exposing the surface to products of a plasma, thereby modifying termination of the surface without significantly affecting bulk properties beneath the surface, and depositing a layer thereover after modifying the surface termination.

EP1195801A2 discloses the use of a dry etch plasma in order to seal the porous side walls of an opening created in a substrate comprising a low-k material layer, thereby maintaining the local low k-value in said low-k material layer.

The use of plasmas in connection with atomic layer deposition was also reported for the field of interconnects (A. Satta et al, Microelectronic Engineering, 60, 2002, pages 59-69; W. Besling et al. International Interconnect Technology Conference, June 2002, IEEE 2002 pages 288-291). It is disclosed that chemical vapor deposited silicon oxycarbide materials treated with plasma are no longer prone to precursor diffusing into this material during ALD. It is further described that ALD onto low dielectric constant (low-k) organic polymer materials results in unacceptable penetration of ALD precursors inside the low-k material.

Due to the surface saturation based growth principle of ALD this technique has been used to deposit the inner surface of porous structures such as in membranes (S. M. George, Journal of Membrane Science, 96, 259-274 (1994)).

On the other hand prevention of precursor penetration is a strict requirement to make substrates useful for certain applications in semiconductor processing. Materials with low dielectric constant (low-k) materials, for example, are used as inter layer dielectric in damascene interconnect structures. Those materials are prone to precursor diffusion and there is a need for making these materials compatible with CVD techniques and in particular with ALD, since the surface saturation based growth principle provokes strong interaction of the substrate surface groups and precursor molecules. Undesired deposition of a metallic barrier inside the dielectric for example increases the leakage current between the metal lines.

In order to achieve thin films by ALD growth the starting surface needs to possess adsorption sites to which the precursors can bind.

If the adsorption site density is low the substrate surface will be covered mainly by growing three-dimensional islands. If the adsorption site density is high the substrate surface will be covered mainly by a two dimensional monolayer. In the case of growing three-dimensional islands the resulting minimal thickness to achieve a continuous ALD film is higher than in the case of mainly two-dimensional ALD growth. Thus, there is a need to modify the polymer surface before ALD in order to create sufficient adsorption sites.

### Aim of the invention

The present invention aims to provide a substrate, useful for semiconductor processing, which has a layer deposited by ALD on a dielectric layer being made of an organic containing material. Further, the present invention aims to provide a method for the deposition of ALD layers onto a dielectric layer made of organic containing material.

### Summary of the invention

In a first aspect of the present invention, a method for depositing a layer on a surface of a dielectric layer substrate is disclosed, said dielectric layer comprising organic containing material. Said method comprises the steps of:
a) exposing said surface of said dielectric layer to a nitrogen containing gaseous substance, thereby modifying the exposed surface of said dielectric layer,
b) depositing a layer by an atomic layer deposition process on said exposed surface of said dielectric layer.

In a first embodiment of this first aspect of the invention; a method as recited above is disclosed wherein said step of exposing a surface of said dielectric layer results in a first region of said dielectric layer, said first region having a first amount of nitrogen incorporated in said dielectric layer and in a second region of said dielectric layer, said second region having said exposed surface and having a second amount of nitrogen incorporated in said dielectric layer, the amount of nitrogen in said second dielectric layer being higher than the amount of nitrogen in said first dielectric layer.

In a further embodiment of this first aspect of the invention, a method as recited in any of the previous embodiments is disclosed wherein said gaseous substance further comprises a compound selected from the group consisting of argon, helium, oxygen and hydrogen.

In a further embodiment of this first aspect of the invention, a method as recited in any of the previous embodiments is disclosed wherein the step of exposing a surface to a nitrogen containing gaseous substance further comprises applying a high frequency power such as e.g. RF or microwave, such that a nitrogen containing plasma is created.

In a further embodiment of this first aspect of the invention, a method as recited in any of the previous embodiments is disclosed wherein said nitrogen containing gaseous substance is selected from the group consisting of N₂, ammonia, hydrogen azide, alkyl derivates of hydrogen azide, hydrazine, salts of hydrazine, alkyl derivates of hydrazine, nitrogen fluoride, hydroxyl amine, salts of hydroxylamine, primary amines, secondary amines, tertiary amines, nitrogen radicals and nitrogen in the excited state.

In a further embodiment of this first aspect of the invention, a method as recited in any of the previous embodiments is disclosed wherein said organic containing material is selected from the group consisting of polyarylethers, hydrogen-silsesquioxanes, methyl-silsequioxanes, polyfluorinated hydrocarbons, polyimides, fluorinated polyimides. benzocyclobutene polymers, and aromatic thermosets.

In a further embodiment of this first aspect of the invention, a method as recited in any of the previous embodiments is disclosed wherein said layer being deposited by an ALD process comprises a metal carbide and/or a metal nitride.

In a further embodiment of this first aspect of the invention, a method as recited in any of the previous embodiments is disclosed wherein said metal is selected from the group consisting of tungsten, titanium and tantalum.

In a further embodiment of this first aspect of the invention, a method as recited in any of the previous embodiments is disclosed wherein said dielectric layer has pores.

In a further embodiment of this first aspect of the invention, a method as recited in any of the previous embodiments is disclosed wherein said pores have a diameter between 0.2 nm and 15 nm.

In a second aspect of this invention, a substrate is disclosed. Said substrate comprises:
- a dielectric layer comprising organic containing material, said dielectric layer having a first region and a second region, said first region having a first amount of nitrogen incorporated and said second region having a second amount of nitrogen incorporated in said dielectric layer, the amount of nitrogen in said second region being higher than the amount of nitrogen in said first region
- a further layer, said layer being in contact with said second region of said dielectric layer and said layer being deposited by atomic layer deposition.

In an embodiment of the second aspect of the invention, a substrate as recited in the second aspect is disclosed wherein said first region and said second region further have a compound incorporated, wherein said compound is selected from the group consisting of argon, helium, oxygen and hydrogen.

In an embodiment of the second aspect of the invention, a substrate as recited in any of the embodiments of the second aspect is disclosed wherein said organic containing material is selected from the group consisting of polyarylethers, hydrogen-silsesquioxanes, methyl-silsequioxanes, polyfluorinated hydrocarbons, polyimides, fluorinated polyimides. benzocyclobutene polymers, and aromatic thermosets.

In an embodiment of the second aspect of the invention, a substrate as recited in any of the embodiments of the second aspect is disclosed wherein said layer is a metal carbide and/or metal nitride.

In an embodiment of the second aspect of the invention, a substrate as recited in any of the embodiments of the second aspect is disclosed wherein said metal is selected from the group consisting of tungsten, titanium and tantalum.

In an embodiment of the second aspect of the invention, a substrate as recited in any of the embodiments of the second aspect is disclosed wherein said dielectric layer has pores.

In an embodiment of the second aspect of the invention, a substrate as recited in any of the embodiments of the second aspect is disclosed wherein said pores have a diameter between 0.2 nm and 15 nm.

### Description of figures.

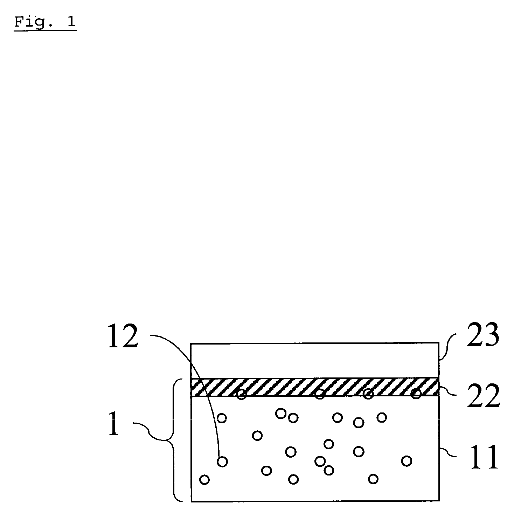

Figure 1 represents a substrate comprising an organic polymer (1), a dielectric layer (11) and a dielectric layer (22) with a nitrogen content higher than in layer (11) .

Figure 2 represents the area density of tungsten (W) atoms as a function of atomic layer deposition cycles for the substrates a) pristine SiLK® (according to example 1) b) oxygen rich nitrogen/oxygen plasma treated SiLK® (according to example 2.1) and c) nitrogen rich nitrogen/oxygen plasma treated SILK® (according to example 2.2).

Figure 3 represents a transmission electron microscopy (TEM) picture of a) pristine SiLK® (according to example 1) and b) nitrogen containing plasma treated SILK® (according to example 2.2), each with an ALD film on top.

Figure 4 represents a Rutherford Backscattering Spectrum tungsten peak of ALD layer on top of a) pristine SiLK® (according to example 1) b) nitrogen rich nitrogen/oxygen plasma treated SiLK® (according to example 2.2).

Figure 5 represents optical angles Psi and Delta observed when an ALD layer is exposed to toluene vapour in a closed chamber. a) example 1, b)example 2.3, 2.4 and 2.5 and 2.6, c)example 2.2 and 2.3, d) example 2.1

Figure 6 represents optical angles Psi and Delta observed when an ALD layer is exposed to toluene vapour in a closed chamber. The ALD layer is deposited on a) pristine SiLK® (according to example 1), b) oxygen rich nitrogen/oxygen plasma treated SiLK® (according to example 2.1) and c) nitrogen rich nitrogen/oxygen plasma treated SiLK® (according to example 2.2).

### Detailed Description

The following description and examples illustrate embodiments of the present invention in detail. Those of skill in the art will recognize that there are numerous variations and modifications of this invention that are encompassed by its scope. Accordingly, the description of embodiments should not be deemed to limit the scope of the present invention.

The present invention discloses a method for depositing a layer on a surface of a dielectric layer, said dielectric layer comprising an organic containing material, said method comprising the steps of:
a) exposing said surface of said dielectric layer to a nitrogen containing gaseous substance, thereby modifying the exposed surface of said dielectric layer,
b) depositing a layer by an atomic layer deposition process on said exposed surface of said dielectric layer.

The present invention discloses a method to effectively enhance growth of ALD deposited layers on dielectric layers being made of organic containing material. Moreover, it was found that the method of the present invention allows to seal the exposed surface of the dielectric layer.

Said method can be used in the process of semiconductor processing, more particularly in the process of back-end processing. The dielectric layer can be present on a substrate. The substrate can be any substrate used in semiconductor processing. Said substrate can be a partly processed or pristine wafer or slice of semi-conductive material, like Si, GaAs, Ge, or an insulating material, e.g. a glass slice or a conductive material. Said substrate can comprise a patterned conductive layer. Particularly, when said substrate is a partly processed wafer or slice, at least a part of an active and/or passive device can already be formed and/or at least a part of the structures interconnecting these devices can be formed.

The term "layer" should be understood to include any layer having a thickness of at least one molecule. Examples of a layer include, but are not limited to, a monolayer, a stack of monolayers, a film with a thickness less than than 50 nm, or a film with a thickness greater than 50 nm.

The dielectric layer comprises organic containing material. The term organic containing material as used in the present invention refers to polymeric material or oligomeric material, which contain organic side groups or contains carbon carbon bonds in the polymer or oligomer backbone. Examples for these compounds are, polyarylethers, hydrogen-silsesquioxanes, methyl-silsequioxanes, polymethylsiloxanes, polyphenylsiloxanes, polyfluorinated hydrocarbons, polyimides, fluorinated polyimides. benzocyclobutene polymers, or aromatic thermosets. Preferred examples are aromatic thermosets, and particularly preferred is SiLK® (registered Trademark, Dow chemical).

The organic material is obtainable by spin coating from an organic polymer/oligomer solution and removal of the solvent, as known by a person skilled in the art.

In case of polymeric material, the organic polymer is preferably, but doesn't have to be, cross linked. Cross linking can be achieved by keeping at elevated temperature for sufficient time and can be carried out in a furnace or on a hot plate. The curing temperature is preferably between 200°C and 500°C, and more preferably between 300°C and 400°C. The temperature treatment can be done before or after the step of depositing the layer by ALD.

Preferably the cross linked organic polymer contains pores, which can be created, e.g. by use of porogens or high boiling solvents, as described in e.g.(Semiconductor International, May 2001, pages 79-85).

The pore size is preferably below 20 nm, more preferably below 10 nm, still more preferably below 5 nm, and most preferably below 2 nm. The porosity is preferably lower or equal to 90 volume percent, more preferably lower or equal to 70 volume percent, still more preferably lower or equal to 50 volume percent and most preferably equal to or lower than 40 volume percent.

Preferably, the nitrogen containing gaseous substance is selected from the group consisting of ammonia (NH₃), hydrogen azide (HN₃) and the alkyl derivates of the said compound such as CH₃N₃, hydrazine (N₂H₄) and salts of hydrazine such as hydrazine hydrochloride, alkyl derivates of hydrazine such as dimethyl hydrazine, nitrogen fluoride NF3, hydroxyl amine (NH₂OH) and its salts such as hydroxylamine hydrochloride, primary, secondary and tertiary amines such as methylamine, diethylamine and triethylamine, and nitrogen radicals such as NH2·, NH·· and N··· wherein "·" means a free electron capable of bonding, and excited state of nitrogen (N₂*).

Said subjecting step can further comprise applying an high frequency power such that a nitrogen containing plasma is created.

The nitrogen containing plasma is preferably generated by subjecting the gaseous substance to a RF power. Preferably the gaseous substance contains nitrogen and/or ammonia. The high frequency power is preferably applied in a chamber in which a top power and more preferably a top power and a bottom power (also called bias) can be applied. The top power used to generate the plasma is preferably between 10 W and 3000 W, more preferably between 10 and 3000 W and most preferably between 100 W and 2000 W. The bottom power used to generate the plasma is preferably between 1 W and 2000 W, more preferably between 10 and 1000 W and most preferably between 50 W and 800 W.

Preferably the plasma is generated in a closed chamber.

Exposing the organic polymer material to the plasma is preferably conducted in a chamber, which may be the same or different (remote plasma) from the chamber in which the plasma is generated.

When the plasma is generated by applying a top power and a bottom power (also called bias), the chamber for generating the plasma and the chamber for exposing the organic polymer material are preferably the same.

The temperature of the organic polymer material during exposure to the nitrogen containing gaseous substance is preferably between -50°C and 400°C, more preferably between 0°C and 250°C, and most preferably between 10°C and 30°C.

The pressure during exposure of the organic containing material to the nitrogen containing gaseous substance is preferably between 1 mTorr and 10 Torr, more preferably between 3 mTorr and 5 Torr, and most preferably between 5 mTorr and 1 Torr.

Said gaseous substance as disclosed in this invention can further comprise a compound selected from the group consisting of argon, helium, oxygen and hydrogen such that a gaseous mixture is formed. The weight ratio of the nitrogen atoms containing molecules e.g., N₂ or e.g. NH₃ to other components in the gaseous mixture is preferably greater than or equal to 1%, preferably greater than or equal 5 %, preferably greather then or equal 10 %, more preferably greater than or equal to 40 % and most preferably greater than or equal to 80 %.

In a preferred embodiment the gaseous mixture contains the gases N₂ and H₂ in a volume ratio between 99 to 1 and 1 to 99, more preferably, between 9 to 1 and 1 to 9, and most preferably between 5 to 1 and 1 to 5.

In another preferred embodiment the gaseous mixture contains the gases N₂ and O₂ in a volume ratio between 99 to 1 and 1 to 99, more preferably, between 9 to 1 and 1 to 9, and most preferably between 5 to 1 and 1 to 5.

In a further preferred embodiment the gaseous mixture contains the gases NH₃ and O₂ in a volume ratio between 99 to 1 and 1 to 99, more preferably, between 9 to 1 and 1 to 9, and most preferably between 5 to 1 and 1 to 5.

The step of exposing a surface of said dielectric layer results in a first region of said dielectric layer(11), said first region having a first amount of nitrogen incorporated in said dielectric layer and in a second region of said dielectric layer (22), said second region having said exposed surface and having a second amount of nitrogen incorporated in said dielectric layer, the amount of nitrogen in said second dielectric layer being higher than the amount of nitrogen in said first dielectric layer.

In the present invention, nitrogen containing groups can be formed on the exposed surface of the dielectric layer. Those nitrogen containing groups can enhance ALD growth.

According to the present invention, a layer (23) is deposited on the exposed surface of the dielectric layer by an atomic layer deposition process. The atomic layer deposition can be thermal or radical enhanced. A preferred deposition temperature for the thermal ALD is between 200°C and 700°C, more preferably between 250°C and 500°C, and most preferably between 275°C and 350°C. A preferred deposition temperature for the radical enhanced ALD is between 0°C and 400°C, more preferably between 20°C and 300°C, and most preferably between 100°C and 200°C.

Preferably, said deposited layer (23) is a metal carbide and/or metal nitride, for example as described in WO0129280A or WO0127347 Preferably said metal is tungsten, titanium tantalum, zirconium, hafnium, vanadium, niobium, chromium and/or molybdenum.

The metal carbide or metal nitride layer is generated from source materials. Typically, suitable metal source materials can be halides, preferably fluorides, chlorides, bromides or iodides, or metal organic compounds, preferably alkylaminos, cyclopentadienyls, dithiocarbamates or betadiketonates of desired metal. The carbide source material can be preferably selected among hydrocarbons and alkyl boranes, wherein the alkyl is typically linear or branched C1 to C4, o-alkyl, preferably C1-C4 alkyls. Particularly preferred is triethyl boron.

The method disclosed in this invention is particularly useful in damascene processing for the deposition of metal barrier layer in an opening being formed in the dielectric layer in damascene processing. The term "dielectric layer" refers to a layer or a stack of layers made of non-conductive material used to electrically isolate layers made of conductive material from each other. Said layer being deposited by atomic layer deposition can be a layer or a stack of layers preventing the diffusion of conductive material (which fills the opening) into the insulating layer. The nature of the barrier layer is determined by the conductive material filling the opening. When the metal is copper, the barrier layer may include, but is not limited to, Ti, TiN, Ta, TaN, TaₓSi_{y}N_{z}, WₓN_{y}, WₓC_{y}N_{z,} SiC, SiOC, hydrogenated SiC, hydrogenated SiOC, and combinations thereof.

In a first embodiment, a method is disclosed for depositing a copper barrier layer in an opening in an dielecric layer formed on a substrate. A dielectric layer comprising organic-containing material is deposited on a substrate. The substrate is preferably a partly processed wafer. The insulating layer (1) can be deposited on a previously fabricated metal level (2), a contact level or a transistor level. In a next step, the insulating layer is patterned, by lithography. During the dry etching process, an opening is formed in the dielectric layer using the dual damascene approach. The etching plasma comprises a nitrogen containing gaseous substance such that an opening is created and such that the exposed surface of the dielectric layer is chemically modified, meaning that nitrogen containing groups are formed on the exposed surface. Subsequently, a barrier layer is deposited using atomic layer deposition technique, based on the exchange of chemical groups. The substrate is brought in contact with a precursor such that the barrier layer is deposited. In a next step, the opening can be filled.

### Examples

### SiLK® deposition

### Example 1

200 mm silicon wafers (Wacker) were cleaned with a mixture containing 1 part NH₃ (Ashland 30 wt. %) 1 part H₂O₂ (30 wt.%) and 5 parts deionized H₂O. A triaminomethyl-silane adhesion promoter, AP4000, was applied. SiLK-I-360 (Dow Chemical) was spin coated and baked at 325°C for 60 s in a TEL Mark 8. The wafers were cured for 30 min at 400°C in a horizontal ASM furnace under N₂ ambient in order to prevent oxidation of the SILK® film. The crosslinking of the polymer is achieved in this last step. The wafers were loaded/unloaded at 200°C and were kept inside the furnace under N₂ during ramp up/down of the furnace temperature (also called pristine SILK®).

### SiLK® surface plasma treatment

### Example 2.1

A treatment of the cross-linked polymer films obtained according to Example 1, was performed in a Mattson Aspen II resist strip chamber for 4 seconds at 230 degree Celsius and 0.5 torr with a gaseous substance composed of 1 volume part nitrogen and 20 volume parts oxygen (also called oxygen rich plasma or ICP treatment). A RF power of 900 Watt was applied.

### Example 2.2

A treatment of the cross-linked polymer films obtained according to Example 1, was performed in a Lam TCP 9100 high-density plasma tool for 4 seconds at 20 degree Celsius and 7 mtorr with a gaseous substance composed of 5 volume parts nitrogen and 1 volume part oxygen (also called nitrogen rich plasma or RIP plasma). A RF power of 1700 Watt was applied. Further a bias (bottom power 600 Watt) was applied.

### Example 2.3

A treatment of the cross-linked polymer films obtained according to Example 1, was performed in a Lam TCP 9100 high-density plasma tool for 5 seconds at 20 degree Celsius and 7 mtorr with a gaseous substance composed of 5 volume parts nitrogen and 1 volume part oxygen (also called nitrogen rich plasma or RIP plasma). A RF power of 1700 Watt was applied. Further a bias (bottom power 600 Watt) was applied.

### Example 2.4

A treatment of the cross-linked polymer films obtained according to Example 1, was performed in a Lam TCP 9100 high-density plasma tool for 5 seconds at 20 degree Celsius and 7 mtorr with a gaseous substance composed of nitrogen. A RF power of 1200 Watt was applied. Further a bias (bottom power 600 Watt) was applied.

### Example 2.5

A treatment of the cross-linked polymer films obtained according to Example 1, was performed in a Lam TCP 9100 high-density plasma tool for 5 seconds at 20 degree Celsius and 7 mtorr with a gaseous substance composed of argon. A RF power of 1200 Watt was applied. Further a bias (bottom power 600 Watt) was applied.

### Example 2.6

A treatment of the cross-linked polymer films obtained according to Example 1, was performed in a Lam TCP 9100 high-density plasma tool for 5 seconds at 20 degree Celsius and 7 mtorr with a gaseous substance composed of amonia. A RF power of 1200 Watt was applied. Further a bias (bottom power 600 Watt) was applied.

After the treatments (Examples 2.1, 2.2, 2.3, 2.4, 2.5 and 2.6), the samples were kept in clean room atmosphere for some days before ALD deposition.

### Atomic layer deposition

A Pulsar2000® reactor (ASM) integrated with an automated wafer handling platform (Polygon®, ASM) was used for deposition of a tungsten based barrier material. This was achieved according to a A,B,C, A... .-type pulse sequence, where individiual A, B, and C stand for the precursors triethylborane ((C₂H₅)₃B, Sigma-Aldrich), tungsten hexaflouride (WF₆), and ammonia (NH₃, Messer-Griesheim), respectively, while A,B,C represents 1 deposition cycle producing WCₓN_{y} (x = 0.7 and y = 0.3). The precursors were led into the reactor through needle and solenoid valves. WF₆ and NH₃ were used as pure compounds, while (C₂H₅)₃B was evaporated and dosed by mixing the liquid precursor with a nitrogen carrier gas flow at 20°C. Excess precursor gas was removed by flowing nitrogen (N₂) for two seconds after each precursor pulse. Residual moisture in the system was reduced below a level of 1 ppb by using gas purifiers (Millipore, Mykrolis GmbH) for N₂ and NH₃, respectively. The temperature during the deposition was about 350 °C, and the maximum pressure was about 2 hPa.

For each of the three substrate types, namely ICP-treated SiLK® (example 2.1), RIP-treated SiLK® (example 2.2) and pristine SiLK® (example 1), samples were produced by applying a number of deposition cycles ranging from 1 to 120.

### Ellipsometric measurements

The barrier film optical properties and thickness were measured by spectroscopic ellipsometer (SE) SENTECH SE801 in the range of 350-870 nm. The measurement results were fitted to a Cauchy model. Refractive index (n) and extinction coefficient (k) of WCₓN_{y} were determined once for the thickest film. At 632.8 nm wavelength n_{WCxNy}=2.99 and k_{WCxNy}=1.57. Then the optical constants of WCₓN_{y} film were fixed to reduce the number of variables to be fitted. The same procedure was applied to the organic polymer SiLK® layer Optical constants were fixed and only thickness was fitted approximated by two Cauchy layers.

Barrier integrity was probed by ellipsometric porosimetry. This technique is usually utilized to measure the structure of porous filmsⁱ. During such measurements, a vacuum chamber is filled with toluene vapor. Adsorption of toluene by a porous film causes a change in its optical properties. Such changes are registered by *in-situ* ellipsometry. If a porous film is sealed by a barrier, it prevents toluene from being inside the film and small changes are observed in the optical properties of the film. This provides of proving the sealing of a porous film barrier.

### Other measurements

The sheet resistance of WCₓN_{y} barrier deposited on pristine SiLK®, and treated SiLK® was measured by a KLA Tencor Rs75 four-point probe. A control wafer of thermal oxide was also processed and measured for comparison.

XPS measurements were performed in a Quantum 2000 from Phi (Q1) with an angle between the sample and the analyser of 45 degree resulting in an information depth of 5 nm.

The analysis was done at a depth of 5 nm and quantification of data was done using the standard Wagner sensitivity factors. Under this condition, the total error for quantification can be assumed to be about 10%.

RBS measurements of the 1-120 cycles ALD^{TM} barrier were performed.

Table 1 illustrates an increased amount of nitrogen for the example of SiLK® (registered Trademark, Dow Chemical) by comparing the elemental composition of the top 10 nm of the layer before and after exposing to a nitrogen containing plasma. The values relate to samples as obtained according to the example of the present invention.

**Table 1:**

| Elemental analysis as determined by X-ray photoelectron spectrometry of organic polymer surface (10 nm) | | | |
|---|---|---|---|
| XPS chemical before and after plasma treatment | | | |
| Sample | C | N | O |
| *Example 1* | 98.1 | <0.1 | 1.9 |
| *Example 2.1* | 76.1 | 1.5 | 22.4 |
| *Example 2.2* | 64.9 | 12.5 | 22.4 |
| *Example 2.3* | 69.9 | 9.2 | 21.0 |
| *Example 2.4* | 61.5 | 22.7 | 15.8 |
| *Example 2.5* | 83.7 | 0.8 | 15.5 |
| *Example 2.6* | 69.4 | 13.3 | 17.3 |

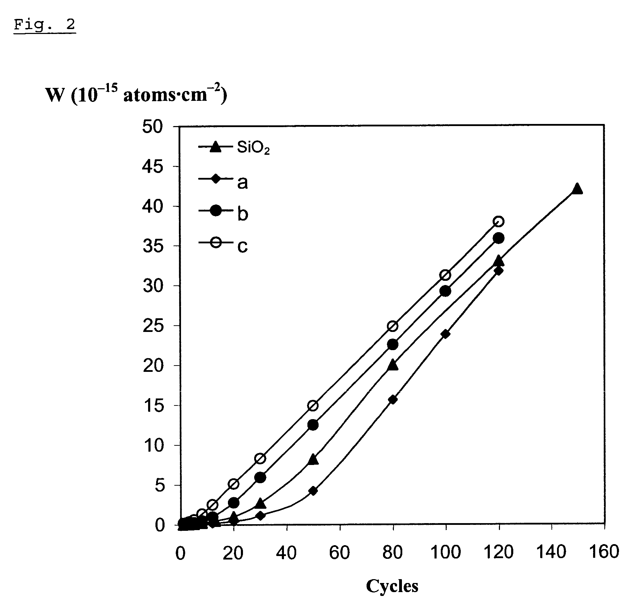

Comparison of ALD growth on different substrates is made in Figure 2, which shows the area density of tungsten atoms in dependence of deposition cycles, as determined by Rutherford back scattering spectroscopy (RBS) on samples obtained according to the Example of the present invention. For reference the growth on a silicon dioxide substrate is also shown. It can be seen that growth on the nitrogen rich nitrogen/oxygen plasma treated sample (according to example 2.2) occurs with a very short transient period indicating a two dimensional growth. Growth on the pristine SiLK® (according to example 1) takes place with an extended transient period indicating mainly island type three dimensional growth. Growth on the oxygen rich nitrogen/oxygen plasma treated polymer surface (according to example 2.1) shows also a faster transition to linear ALD typical behaviour. A comparison to the growth on SiO₂ in Figure 2 illustrates that the treatments are very effective in enhancing ALD growth on organic polymer surfaces. The slope of the sample on pristine SiLK® is higher than on the plasma treated ones. This indicates that the linear part of the growth has not been reached at one hundred cycles. Due to the three dimensional shape of growing ALD islands the total surface available for precursor adsorption during ALD increases first during island formation and then decreases during coalescence of the islands. Therefore, the growth curves with pronounced three dimensional growth have S- type shape (cf. SiO2 reference substrate Figure 2). Hence, the substrates of the present invention have a distinct advantage of enabling very thin but nevertheless continuous ALD films on top of an organic polymer material.

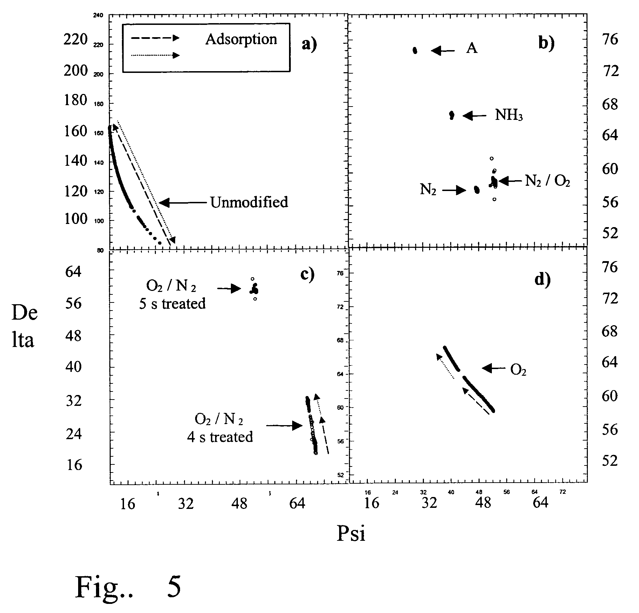

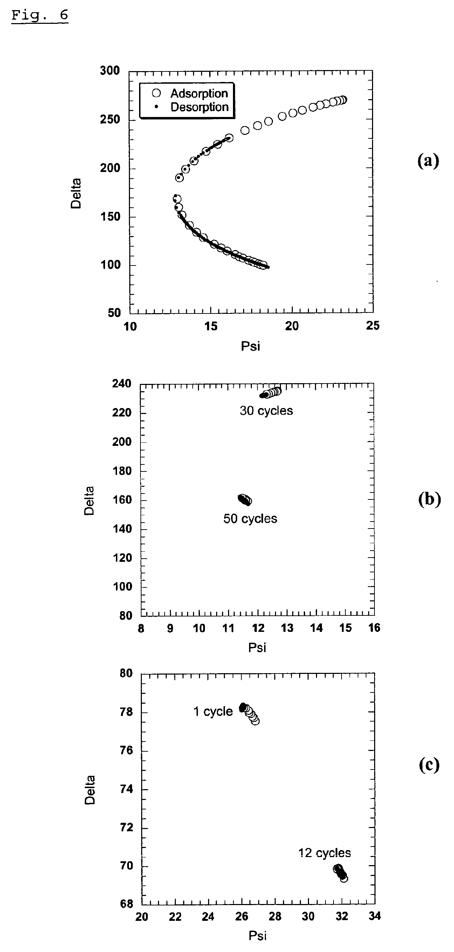

This is further illustrated in Figures 5 and 6, which show permeability of substrates of the present invention to toluene vapour. Toluene vapour can penetrate through imperfections in the film and be absorbed by the polymer material causing changes in optical properties. Changes in optical properties, namely of the ellipsometric angles Psi and Delta of the polymer or polymer-ALD film system are monitored while being exposed to toluene vapour in a closed chamber. Systems to do these kind of measurements are commercially available, e.g. from XPEQT, Switserland. In Figure 5 and 6, the absorption or adsorption is indicated by large open circles and the desorption is indicated by small filled circles. In Figure 5 graph a) refers to the untreated sample (according to example 1). The ellipsometric angles Psi and Delta change largely indicating adsorption of toluene into the sample. This change is reversible indicating the presence of large porous into the samples. In Figure 5 graph d) refers to the O₂ treated sample (ICP) sample (according to example 2.1). The same experiment has been done for example 2.1, 2.2, 2.3, 2.4, 2.5 and 2.6, indicating an improved behaviour of the dielecrric layer compared to example 1. The ellipsometric angles Psi and Delta change indicating adsorption of toluene into the sample. This change is irreversible meaning that the pores are small. In Figure 5 graph b) refers to the Argon, nitrogen, ammonia and O₂/N₂ treated samples (according to examples 2.3, 2.3, 2.5, and 2.6). The ellipsometric angles Psi and Delta do not change indicating a sealed sample where toluene cannot penetrate. In Figure 5 graph c) refers to the O₂/N₂ treated sample (RIP) sample (according to example 2.2 and 2.3). The ellipsometric angles Psi and Delta change slightly when the treatment is done for 4 s (example 2.2) indicating adsorption of toluene into the sample but they do not when the treatment is done for 5 s (example 2.3).

In Figure 6 graph a) refers to a sample with 120 cycle ALD film on top of untreated SilK® surface (according to example 1); graph b) shows two curves (30 and 50 cycles ALD film) relating to oxygen rich nitrogen/oxygen plasma treated SiLK® (according to example 2.1); and graph c) shows two curves (1 and 12 cycles ALD film) relating to nitrogen rich nitrogen/oxygen plasma treated SiLK® (according to example 2.2). The different observations from figure 6 can be related to the integrity of the ALD film. From the graphs it can be concluded that the ALD film obtained with 120 deposition cycles on pristine SILK® is completely permeable to toluene vapour, while the ALD film obtained with the other conditions (according to example 2.1 and 2.2) are good. The preferred conditions are 50 deposition cycles on oxygen rich nitrogen/oxygen plasma treated SiLK® (according to example 2.1), which is substantially impermeable to toluene vapour and the ALD film obtained with 12 deposition cycles on nitrogen containing plasma treated SilK® (according to example 2.2), which is also substantially impermeable to toluene vapour.

A further advantage constitutes the homogeneity of the ALD film in the substrates of the present invention. Samples obtained according to the Example of the present invention on 200 mm silicon wafers were characterized by sheet resistance. The within wafer non uniformity (WIWNU) of sheet resistance measured with a KLA TENCOR RS75 four point probe (polar forty nine point map with 5 mm edge exclusion) for 120 cycles WCN ALD film on top of pristine SilK® is 25% in terms of the 1 sigma standard deviation, the 120 cycle WCN deposited in the same manner on SiLK® treated with nitrogen rich nitrogen/oxygen plasma produces a substrate of the present invention with a WIWNU of 33% in terms of the 1 sigma standard deviation.

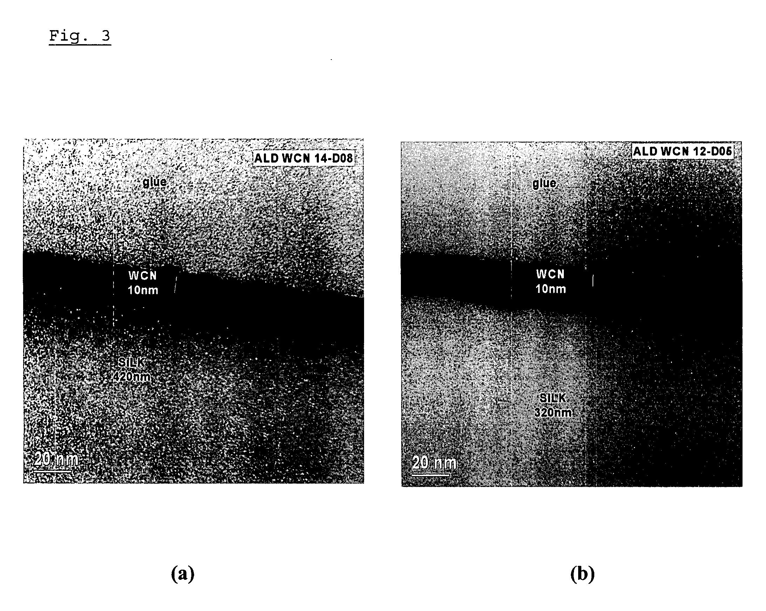

Transmission electron microscope pictures of Figure 3 illustrate formation of islands in the ALD deposited layer on the organic polymer substrates (a, according to example 1), while a continuos ALD film is observed on nitrogen rich nitrogen/oxygen plasma treated film (b, according to example 2.2). Further it can be seen from Figure 3 that the substrate of the present invention (b) has a sharp interface between organic polymer material and ALD film. In contrast thereto, the sample of Figure 3 a) shows dark dots inside the polymer layer, which indicates penetration of precursors and consequent deposition of material within the bulk of the polymer layer.

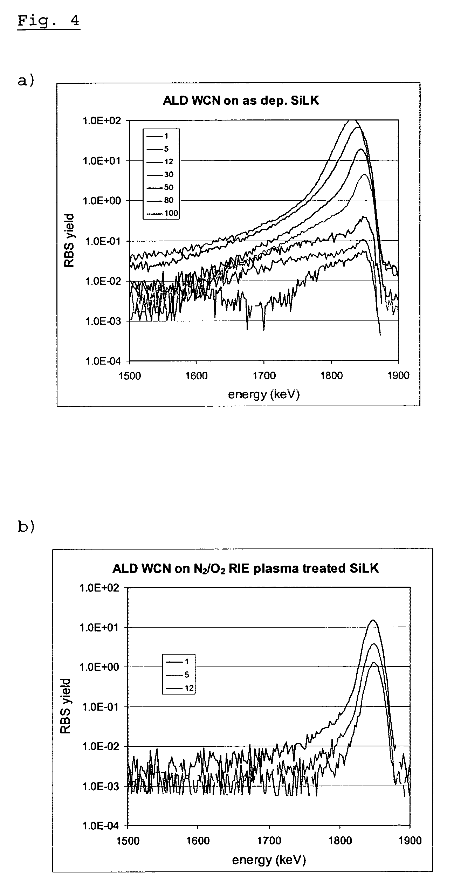

Figure 4 also illustrates the advantage of the substrates of the present invention. RBS tungsten peaks of substrates of the present invention are almost symmetrically distributed around its centre (b), and the tungsten peak of an ALD film on organic polymer substrate, which has not been exposed to nitrogen containing plasma before ALD deposition has an extended tail (a). The asymmetry indicates diffusion of tungsten into the organic polymer layer.

## Claims

1. A method for depositing a layer on a surface of a dielectric layer, said dielectric layer comprising an organic containing material, said method comprising the steps of:
a) exposing said surface of said dielectric layer to a nitrogen containing gaseous substance, thereby modifying at least the exposed surface of said dielectric layer,
b) depositing a layer by an atomic layer deposition process on said exposed surface of said dielectric layer.

2. The method according to claim 1 wherein said step of exposing a surface of said dielectric layer results in a first region of said dielectric layer, said first region having a first amount of nitrogen incorporated in said dielectric layer and in a second region of said dielectric layer, said second region having said exposed surface and having a second amount of nitrogen incorporated in said dielectric layer, the amount of nitrogen in said second region of said dielectric layer being higher than the amount of nitrogen incorporated in said first region of said dielectric layer.

3. The method according to any of the previous claims, wherein said gaseous substance further comprises a compound selected from the group consisting of argon, helium, oxygen and hydrogen.

4. The method according to any of the previous claims wherein the step of exposing said surface to a nitrogen containing gaseous substance further comprises applying an RF power such that a nitrogen containing plasma is created.

5. The method according to any of the previous claims wherein said nitrogen containing gaseous substance is selected from the group consisting of N₂, ammonia, hydrogen azide, alkyl derivates of hydrogen azide, hydrazine, salts of hydrazine, alkyl derivates of hydrazine, nitrogen fluoride, hydroxyl amine, salts of hydroxylamine, primary amines, secondary amines, tertiary amines, nitrogen radicals and nitrogen in the excited state.

6. The method according to any of the previous claims wherein said organic containing material is selected from the group consisting of polyarylethers, hydrogen-silsesquioxanes, methyl-silsequioxanes, polyfluorinated hydrocarbons, polyimides, fluorinated polyimides. benzocyclobutene polymers, and aromatic thermosets.

7. The method according to any of the previous claims wherein said layer being deposited by an ALD process comprises a metal carbide and/or a metal nitride.

8. The method according to any of the previous claims wherein said metal is selected from the group consisting of tungsten, titanium and tantalum.

9. The method according to any of the previous claims wherein said dielectric layer has pores.

10. The method according to claim 9 wherein said pores have a diameter between 0.2 nm and 15 nm.

11. A substrate comprising:
- a dielectric layer comprising an organic containing material, said dielectric layer having in a first region (11) and a second region (22), said first region having a first amount of nitrogen incorporated and said second region having a second amount of nitrogen incorporated in said dielectric layer, the amount of nitrogen in said second region (22) being higher than the amount of nitrogen in said first region
- a further layer (23), said layer being in contact with said second region of said dielectric layer and said layer being deposited by atomic layer deposition.

12. The substrate according to claim 11 wherein said first region and said second region further have a compound incorporated, wherein said compound is selected from the group consisting of argon, helium, oxygen and hydrogen.

13. The substrate according to claim 11 or 12 wherein said organic containing material is selected from the group consisting of polyarylethers, hydrogen-silsesquioxanes, methyl-silsequioxanes, polyfluorinated hydrocarbons, polyimides, fluorinated polyimides. benzocyclobutene polymers, and aromatic thermosets.

14. The substrate according to any of claims 11 to 13 wherein said layer (23) is a metal carbide and/or metal nitride.

15. The substrate according to any of claims 11 to 14 wherein said metal is selected from the group consisting of tungsten, titanium and tantalum.

16. The substrate according to any of claims 11 to 15 wherein said dielectric layer (1) has pores (12).

17. The substrate according to claim 16 wherein said pores have a diameter between 0.2 nm and 15 nm.
